## Europäisches Patentamt

## European Patent Office

## Office européen des brevets

(19)

(11) Publication number: **0 081 951**
A2

(12) **EUROPEAN PATENT APPLICATION**

(21) Application number: **82306417.5**

(22) Date of filing: **02.12.82**

(51) Int. Cl.³: **H 01 L 29/60, G 11 C 11/34**

(30) Priority: **16.12.81 US 331473**

(43) Date of publication of application: **22.06.83**
**Bulletin 83/25**

(84) Designated Contracting States: **DE FR GB NL**

(71) Applicant: **INMOS CORPORATION, P.O. Box 16000, Colorado Springs Colorado 80935 (US)**

(72) Inventor: **Lancaster, Arthur L., 5010 Brady Road, Colorado Springs Colorado 80915 (US)**

(74) Representative: **Palmer, Roger et al, Page, White and Farrer 27 Chancery Lane, London WC2A 1NT (GB)**

(54) **A semiconductor memory cell.**

(57) A semiconductor memory cell of reduced size for a semiconductor memory having rows of such memory cells. The cell is a non-volatile memory cell and includes first (A) and second (C) gates insulated from a silicon substrate (26) to form a pair of MOS transistors. A storage transistor is formed by a third gate (B) which is disposed between the other two gates (A and C) and which in insulated from the substrate (26) by material (36, 38) suitable for forming a storage transistor with the third gate (B). A drain region (14) is disposed In the substrate preferably adjacent to the second gate (C) and a source region is disposed in the substrate preferably adjacent to the first gate (A). Thus, the first gate (A) can isolate the storage transistor from the source region (16) to permit the source to be coupled to other cells in the same row and thereby act as a common source for an entire row of cells.

## A semiconductor memory cell

The invention relates to a semiconductor memory cell for a semiconductor memory and generally to improvements in non-volatile semiconductor memories.

Conventional non-volatile semiconductor memories such as EE PROM's (Electrically Erasable Programmable Read Only Memories) include rows of memory cells which store data representative of logical ones and zeros. The amount of data which can be stored in such a memory depends, therefore, on the number of memory cells which can be included on a single chip. To increase the amount of data which a memory can store, one can increase the number of cells on the chip either by increasing the size of the chip or by increasing its packing density. The latter alternative is preferred.

Factors which limit the packing density of memory cells of the type under consideration are the number of metal lines required to access the components of each cell and the number of metal contacts required between a cell and the metal lines. Conventional memory cells require two metal lines and two half contacts per cell.

Another factor which influences the packing density of memory cells is the number and layout of the gate electrodes of each cell. Typical memory cells employ two gates, one for a programmable transistor and another for a normal MOS transistor. The two gates are separated from each other, and the channel beneath them must be completed by an additional N+ diffusion in the substrate.

The factors mentioned above result in each conventional non-volatile memory cell having an area of about 400 square microns. The present invention provides

-2-

a memory cell structure which substantially decreases the area of each memory cell and which provides a corresponding increase in the packing denisty of a non-volatile semiconductor memory.

It is a general object of the invention to provide an improved non-volatile memory cell.

It is a more specific object of the invention to provide a non-volatile memory cell whose size is substantially reduced in comparison to the size of conventional non-volatile memory cells.

It is another object of the invention to provide a non-volatile memory cell having fewer metal lines and fewer metal contacts than conventionally employed.

One way of carrying out the invention is described in detail below with reference to the drawings which illustrate one specific embodiment in which:

Figure 1 is a plan view of a portion of a semiconductor chip showing an individual memory cell 10 and approximately three more such cells constructed in accordance with the invention;

Figure 2 is a cross sectional view of the cell 10 taken along lines 2-2 in Figure 1;

Figure 3 is the same cross sectional view as Figure 2 and illustrates the bias conditions used for programming the illustrated memory cell;

Figure 4 is the same cross sectional view as Figure 2 and illustrates the bias conditions used for program inhibiting the illustrated cell; and

Figure 5 is the same cross sectional view as Figure 2 and illustrates the bias conditions used for reading the illustrated memory cell.


The memory cell construction described herein includes a substrate above which three gates, made of polysilicon for example, are disposed.  First and second gates are disposed above the substrate at substantially the same level and insulated from the substrate to form a pair of MOS transistors.  The third gate is formed of a higher level of polysilicon or other material and is disposed between the first and second gates and insulated from the substrate by material which forms, with the third gate and the substrate, a non-volatile storage transistor.  A drain region and a source region are disposed in the substrate and adapted to receive bias potentials for programming and reading the storage transistor.

Preferably, the drain region is substantially adjacent the second gate and the source region is substantially adjacent the first gate.  With this arrangement, the MOS transistor formed by the first gate may be turned off to isolate the storage transistor from the source region.  Hence, the source may be biased to allow programming of selected cells in a row and simultaneous program inhibiting of other cells in the same row. By use of a common source, the need for individual metal lines and contacts to access the source of individual cells is avoided.  Therefore, the size of the memory cells is decreased and packing density is increased.


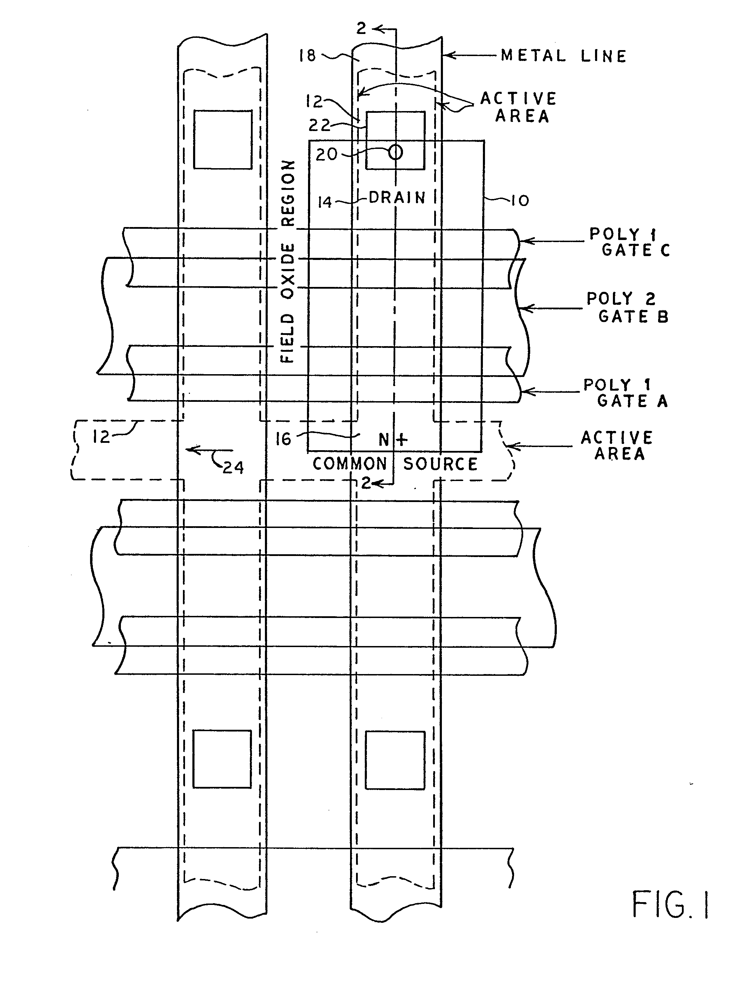

Referring to Figure 1, an improved non-volatile memory cell construction is shown which exhibits improved packing density. The illustrated embodiment uses double level polysilicon gate MOS (metal oxide semiconductor) technology and is particularly adapted for use in EE PROMs. The gates can also be made of other suitable materials such as refractory metals, refractory metal silicides, or aluminum.

The illustrated construction shows a chip area which includes approximately four memory cells. The approximate boundaries of one of the cells 10 is included within the solid line rectangle. In this rectangle, a memory cell is formed which includes two normal MOS transistors and a programmable, non-volatile storage transistor. A single drain region and a single source region are included in each memory cell to receive selected bias potentials which cause the memory cell to be programmed, erased, and the like.

Also shown in this figure is a dashed line 12 which defines an active area within which all transistors and diffused junctions are included. First levels of polysilicon define "poly 1" gates A and C and another, higher level of polysilicon defines a "poly 2" gate B. The active area bounded by the line 12 forms normal MOS transistors wherever the gates A and C cross the active area. Where the poly 2 crosses the active area, a non-volatile storage transistor is formed (with a nitride and oxide sandwich between the poly 2 gate and the substrate).

Wherever the active area is not covered by poly 1 or poly 2, an N+ source or drain diffusion results. For example, a drain region 14 and a source region 16 are formed for the cell 10.

The N+ drain region 14 is connected to a metal line 18 through a contact region 20 defined by a metal contact 22. This metal line receives bias voltages for use in programming and reading data from the cell 10.

It should be noted that only about half of the contact 22 is used to connect to the drain region 14. The upper half of the contact 22 may be used to make contact with the drain region of another cell immediately above the cell 10.

The source region 16 does not require its own metal contact for the cell 10 or for any other individual cells which are in the same row as the cell 10. Moreover, the active area which forms the source region 16 extends in the direction of the arrow 24 (and in the reverse direction) completely through a row of cells to form additional source regions for each cell in the row. Hence, a common source is established for each cell in the row occupied by the cell 10. It is also common to all cells in the immediately adjacent row of cells below the cell 10. As described in more detail below, this use of a common source line is made possible primarily by the inclusion of the poly 1 gate A, and it eliminates the need for an additional metal line and a half contact per cell to provide separate source connections for each cell in a row. Thus, each cell requires but a half contact and a single metal line, thereby improving packing density.

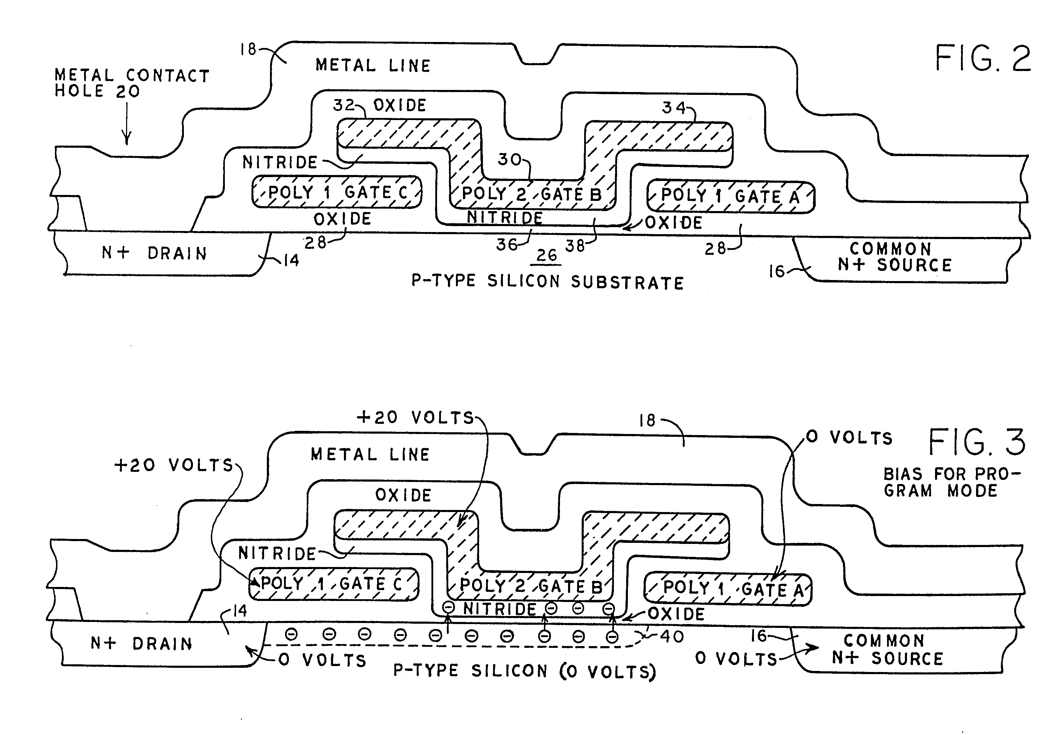

Referring now to Figure 2, a cross section of the cell 10 is shown for further describing the cell construction and its operation. The description which follows is in terms of N-channel devices, but it applies equally to P channel devices if all voltage polarities are reversed and if the P and N type silicon regions are reversed.

The N+ source 16 and drain 14 diffusions are diffused into a P-type silicon substrate 26 or preferably, into a deep P-type diffusion in an N-type substrate. As shown, the poly 1 gates A and C are disposed above and insulated from the substrate by a layer of silicon dioxide 28. The oxide thickness between the substrate and gates A and C is typically from 500 to 1,000 angstroms. Thus, two enhancement type MOS transistors are formed, the gates of which are disposed at substantially the same given level above the substrate.

The poly 2 gate B includes a central portion 30 disposed between the gates A and C, and end portions 32 and 34 which are situated above and overlap the gates A and C. Separating the central portion 30 from the substrate is a dielectric sandwich comprising a silicon dioxide layer 36 whose thickness is typically from 20 to 50 angstroms, and a thicker (300 to 500 angstroms) layer 38 of silicon nitride. Both these layers extend under the end portions 32 and 34 of gate B and separate this gate from gates A and C. In the region where the oxide layer 36 extends vertically and horizontally to separate gate B from gates A and C, its thickness may be increased to somewhat greater than 1,000 angstroms. In this manner, the gate B, along with the substrate and the nitride layer 38 and the oxide layer 36, form a MNOS non-volatile storage transistor. Because the gate B overlaps gates A and C, a continuous channel is developed (with proper bias conditions) from the drain 14 to the source 16 without requiring one or more additional N+ diffusion regions in the substrate between the drain and source.

As shown in this Figure, the drain region 14 is disposed in the substrate at a location which is substantially adjacent the gate C, and the source region 16 is disposed in the substrate at a location which is substantially adjacent the gate A. Thus, the gate A can isolate the gate B from the source 16 so that the storage transistor can be programmed or inhibited from programming, irrespective of the potential on the source 16. Hence, while the storage transistor in the cell 10 is being programmed (data written in), the bias on the drain 14 may be selected to enable other cells in the same row to be program inhibited. In this matter, the number of metal lines and contacts is reduced because individual source regions in the same row need not be separately accessed. The description below more fully describes how the gate A provides this advantage.

Turning now to Figure 3, the bias conditions necessary for programming the cell are shown. Data storage in the cell is accomplished by modification of the MOS threshold voltage (Vth) of the poly 2 gate region of the cell. Specifically, the program mode is used to raise Vth in the cell to indicate the storage of a data "1". This threshold change occurs when the bias levels shown in Figure 3 are applied. As shown, poly 1 gate C and poly 2 gate B are both raised to 20 volts. The N+ drain and source and the gate A are all held at zero volts. Under these conditions, gates C and B both turn on and an electron inversion layer 40 forms under them. Note that no inversion exists under gate A since it is at zero volts. With 20 volts applied to gate B, the electric field from this gate to the inversion layer is sufficiently high to cause electrons to tunnel through the very thin oxide layer into the dielectric sandwich under gate B. As is well known, there are many trapping centers in a nitride-oxide sandwich into which many of these electrons fall. This buildup of negative charge in the dielectric raises the Vth of gate B to a relatively high positive value, about +5 volts. No electrons tunnel into the oxide under gate C even though it is also at 20 volts due to the thicker oxide layer present there. In this manner, the illustrated cell is programmed to store a data "1".

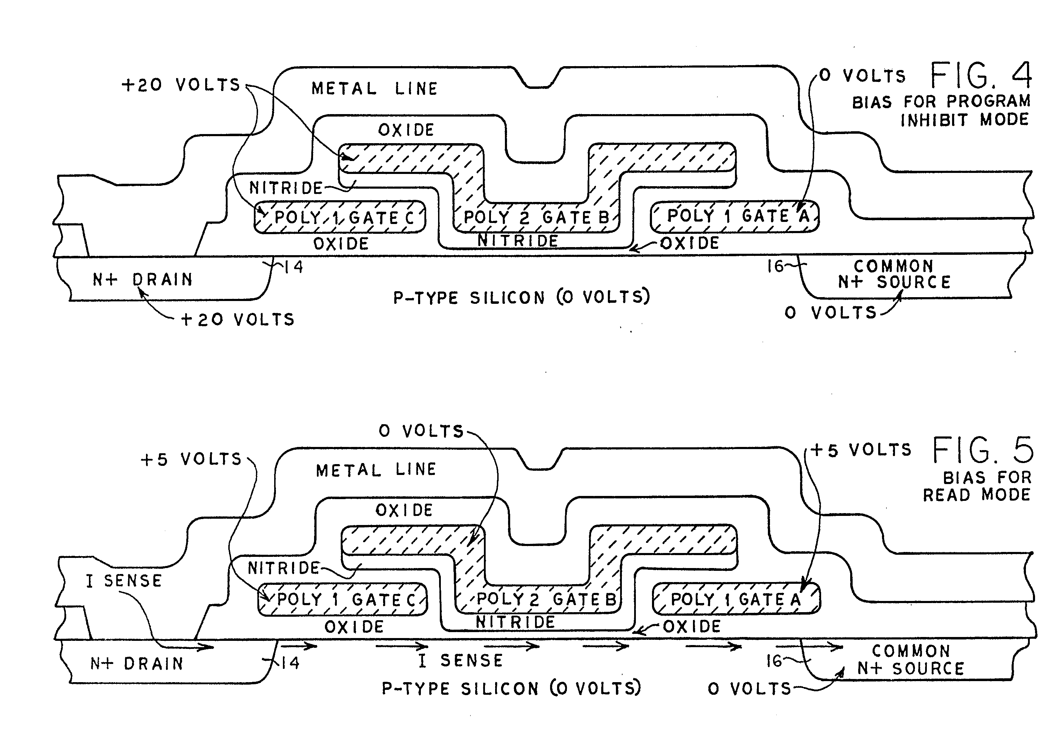

Referring to Figure 4, the bias conditions are shown for inhibiting the programming of a cell. In this program inhibit mode, selected cells in the same row are allowed to retain their previously established Vth (and their same data storage) while one or more other cells in the same row are being programmed. All bias conditions are the same as for the program mode, except that the drain region 14 is held at the potential (20 volts) of gates B and C. This prevents gate C from turning on, as indicated by the lack of an electron inversion layer.

Gate A now functions to isolate the common source 16 from the region under gate B so that a channel cannot be formed there. With gate A at zero volts, it cannot turn on, even with the common source 16 at zero volts. Because no inversion layer electrons are present under gate B, none can tunnel into the dielectric layer to change the Vth of the storage transistor.

The program inhibit mode described above allows one or more selected cells in a row to be programmed while the remaining cells in that row are program inhibited. As shown in Figure 1, this is accomplished by routing a drain bias of zero volts to cells which are to be programmed via the metal line 18 which runs perpendicularly to the row gates A, B and C. The non-selected cells in the same row are inhibited by applying 20 volts to their drains. The common source contacts each cell in the same row and receives a bias of zero volts. Thus, the cells selected for programming and the non-selected cells in the same row do not require different source biases because the gate A isolates gate B of each cell from the ground potential on the common source. Without gate A, the source for a particular cell would have to be held at 20 volts to inhibit programming, and this would require a separate metal line and contact for the source, as is found in conventional non-volatile memories.

The data stored in the cell is read by applying the bias potentials shown in Figure 5. Poly 1 gates A and C are held at 5 volts, gate B is held at zero volts, and the common source is held at zero volts. Bias for the drain may be provided by coupling the drain's metal line to a 5 volt bias through a resistor.

If the cell had been previously erased to store a data "0", then the storage transistor will have a negative Vth. In that case, sense current flows between the drain 14 and the source 16 because the gate B turns on with these bias potentials. The state of the cell can be read conventionally by coupling a sense amplifier to the cell's metal drain line.

If the cell had been previously programmed to store a data "1", then the storage transistor will have a positive Vth and will not turn on under these bias conditions. Hence, no sense current will flow from drain to source and a sense amplifier can interpret such a lack of current as a data "1".

To erase the data stored in the cell, a bias of +20 volts is applied to the P-type silicon under the gates and to the drain and source regions. Alternately, drain and source regions may be allowed to float and to follow the potential of the P-type silicon up to a diode drop below 20 volts.

Poly gates A and C may float in the erase mode, but the poly 2 gate B is held at zero volts. Consequently, the 20 volt bias on the P-type silicon develops an electric field which induces electrons in the nitride layer 38 to tunnel back into the P-type silicon under the gate B. The result is that the threshold voltage of the storage transistor is returned to a low value (typically -5 volts).

Preferably, the P-type silicon region is formed as a diffused P-well region in an N-type silicon wafer.

This allows the P-type silicon regions to be internally switched from ground to +20 volts to facilitate erase control for a user.

An erase inhibit mode is also used to prohibit erasing an entire row of cells while one or more other rows of cells are being erased. The bias conditions for the erase inhibit mode are the same as the bias conditions for the erase mode except that the bias on both the P-substrate and on gate B is held at +20 volts. This results in insufficient electric field to force any electrons in the nitride layer 38 to tunnel into the P-type silicon below. Hence, no Vth charge occurs for cells in a row which receives erase inhibit biases.

It will be appreciated that the memory cell construction described above provides an increased packing density so that a greater number of memory cells can be included in a given chip area. This is primarily because this memory cell construction eliminates a metal line and a half metal contact per cell.

Although the invention has been described in terms of a preferred construction of a memory cell, it will be obvious to those skilled in the art that many alterations and modifications may be made without departing from the invention. Accordingly, all such alterations and modifications are intended to be considered as within the spirit and scope of the invention as defined by the appended claims.

Claims:

1. A semiconductor memory cell for a semiconductor memory having rows of memory cells for storing data therein, the cell (10) comprising a substrate (26); a first gate (A) situated at a given level above the substrate (26) and insulated from the substrate; a second gate (C) situated at substantially the same given level above the substrate (26) and insulated from the substrate; a third gate (B), at least a part of which is disposed between the first and second gates and insulated from the substrate by material which forms, with the third gate (B) and the substrate (26), a non-volatile storage transistor; and a drain region (14) and a source region (16) disposed in the substrate (26) and adapted to receive bias potentials for programming and reading the storage transistor.

2. A memory cell as claimed in Claim 1, wherein the memory cell (10) is one of a plurality of memory cells in a row of memory cells, and wherein said source (16) is common to all memory cells in the row of cells.

3. A memory cell as claimed in Claim 1 or Claim 2, wherein the third gate (B) at least partly overlaps the first (A) and second (C) gates to permit a substantially continuous channel to be produced under all three gates.

4. A memory cell as claimed in any one of Claims 1 to 3, wherein the source region (16) is substantially adjacent the first gate (A) and the drain region (14) is substantially adjacent the second gate (C).

5. A semiconductor memory cell for a semiconductor memory having rows of memory cells for storing data therein, the cell (10) comprising a substrate (26); a first polysilicon gate (A) situated at a given level above the substrate (26) and insulated from the substrate; a second polysilicon gate (C) situated at substantially the same given level above the substrate (26) and insulated from the substrate; a third polysilicon gate (B) having a central portion (30) disposed between the first (A) and second (C) gates, and end portions (34, 32) which are situated above said first (A) and second (C) gates so as to overlap said first and second gates, said third gate (B) being insulated from the substrate (26) by material (36, 38) which forms, with the third gate (B) and the substrate (26), a non-volatile storage transistor; a drain (14) disposed in the substrate (26) substantially adjacent to the second gate (C); and a source (16) disposed in the substrate substantially adjacent to the first gate (A), whereby a continuous channel may be formed between the source (16) and drain (14) region by application of appropriate bias potentials to the gates and to the source and drain regions, and the first gate (A) isolates the third gate (B) from the source region (16) when programming and programming inhibit bias potentials are applied to the drain (14) and source (16) and to the gates so that the source (16) may be common to other cells in a row of cells.

0081951

FIG. I

# FIG. 2

METAL CONTACT
HOLE 20

18 — METAL LINE

32 — OXIDE

34

NITRIDE

30

POLY 1 GATE C

POLY 2 GATE B

POLY 1 GATE A

OXIDE

NITRIDE

OXIDE

N+ DRAIN

28

14

36

26

38

28

16

COMMON
N+ SOURCE

P-TYPE SILICON SUBSTRATE

---

# FIG. 3

+20 VOLTS

18

0 VOLTS

+20 VOLTS

METAL LINE

BIAS FOR PRO-
GRAM MODE

OXIDE

NITRIDE

POLY 1 GATE C

POLY 2 GATE B

POLY 1 GATE A

⊖ NITRIDE ⊖ ⊖ ⊖

OXIDE

N+ DRAIN

14

⊖ ⊖ ⊖ ⊖ ⊖ ⊖ ⊖ ⊖ ⊖ ⊖ ⊖ ⊖ ⊖ 40

16

0 VOLTS

0 VOLTS

P-TYPE SILICON (0 VOLTS)

0 VOLTS

COMMON
N+ SOURCE

FIG. 4
BIAS FOR PROGRAM INHIBIT MODE

+20 VOLTS — METAL LINE — 0 VOLTS

OXIDE

NITRIDE

POLY 1 GATE C   POLY 2 GATE B   POLY 1 GATE A

OXIDE   NITRIDE   OXIDE

N+ DRAIN   14   16   COMMON N+ SOURCE

P-TYPE SILICON (0 VOLTS)

+20 VOLTS   0 VOLTS

FIG. 5
BIAS FOR READ MODE

0 VOLTS

+5 VOLTS — METAL LINE   +5 VOLTS

OXIDE

I SENSE   NITRIDE

POLY 1 GATE C   POLY 2 GATE B   POLY 1 GATE A

OXIDE   NITRIDE   OXIDE

N+ DRAIN   14   I SENSE   16   COMMON N+ SOURCE

P-TYPE SILICON (0 VOLTS)   0 VOLTS